# EUROPEAN PATENT APPLICATION

(11) **EP 3 608 883 A1**
(43) Date of publication of application: **12.02.2020**
(21) Application number: 18187428.0
(22) Date of filing: 06.08.2018
(51) Int. Cl.: G07C 9/00, B60R 25/23, G06F 3/02, B60L 58/12

(54) **KEYPAD FOR UNLOCKING OR LOCKING THE OPENING OF AN ELECTRIC VEHICLE**

(71) Applicant: DURA Automotive Holdings U.K., Ltd., Birmingham, B35 7AG (GB)
(72) Inventor: FARGES, Thomas, 91940 Gometz le Châtel (FR)
(74) Representative: Cabinet Laurent & Charras

(57) **Abstract**

The invention concerns a keypad (10) for unlocking/locking at least one opening of an electric vehicle, the keypad (10) comprising at least three keys (80) including a first key (81), a second key (82) and a third key (83); wherein the keypad (10) includes a light system (12) comprising: at least three light zones (20) including a first light zone (21) provided with the first key (81), a second light zone (22) provided with the second key (82), and a third light zone (23) provided with a third key (83); and a set of diodes for illuminating the light zones (20) in different colors (R, Y, G); wherein in a first mode (M1), the light system (12) displays an information relative to the electric vehicle (1), while in a second mode (M2), the light system (12) displays the keys (80) illuminated with different colors (R, Y, G). The invention also concerns a method for indicating a state of charge of an electric vehicle.

## Description

### TECHNICAL FIELD OF THE INVENTION

The invention concerns a keypad and a method for unlocking/locking at least one opening of an electric vehicle, such as the electric charging hatch.

### BACKGROUND OF THE INVENTION

Keypads for unlocking/locking doors or other openings are well-known in the field of automotive vehicles.

US2010315267A1 discloses a system for unlocking the doors of a vehicle by pressing a series of keys according to a predetermined sequence, and for locking them by pressing two keys simultaneously for a predetermined duration.

US2015360646A1 describes another example of a system for locking and unlocking doors of a vehicle. The system comprises two user interfaces, grouped together on a single capacitive keypad or distributed over two separate capacitive keypads.

### SUMMARY OF THE INVENTION

The aim of the invention is to provide a multifunctional keypad accessible from outside the vehicle.

To this end, the invention concerns a keypad for unlocking/locking at least one opening of an electric vehicle, the keypad comprising at least three touch keys including a first touch key, a second touch key and a third touch key.

According to the invention, the keypad includes a light system comprising: at least three light zones including a first light zone provided with the first touch key, a second light zone provided with the second touch key, and a third light zone provided with a third touch key; and a set of diodes for illuminating the light zones in different colors; wherein in a first mode, the light system displays an information relative to the electric vehicle, while in a second mode, the light system displays the touch keys illuminated with different colors.

Thanks to the invention, the keypad provides two different functions on a single location of the electric vehicle, preferably next to the electric charging hatch. In the first mode, the user can see an information relative to the vehicle, for example the level of charge of the electric vehicle. In the second mode, the user can unlock or lock one or several openings by touching a predetermined sequence of colors on the keypad.

Advantageously, the keypad can be used for unlocking/locking the electric charging hatch, in order to connect the electric vehicle to the power network, when the user does not have the vehicle keys. In addition, the keypad can be used for unlocking/locking other openings, such as the doors and the rear trunk of the electric vehicle.

According to further aspects of the invention which are advantageous but not compulsory, such a keypad may incorporate one or several of the following features.
- Preferably, in the first mode, the information displayed by the light system is a state of charge of the electric vehicle. Alternately, the information displayed by the light system may be a signal quality level, a parking payment time, a vehicle rent time, etc.
- Still preferably, the second mode is activated by pressing one of the touch keys. Advantageously, the transition from the second mode to the first mode can be made automatically after a predetermined time without pressing one of the touch keys.
- According to a particular embodiment, in the second mode, when a user enters an unknown sequence, the light zones are illuminated with a predetermined pattern during a predetermined time. For example, the light zones flash each in turn during 0,1 second, every 0,3 second, for a total duration of 1,2 second.
- According to a preferred embodiment, the touch keys are capacitive keys. Alternately, the touch keys may be resistive keys.
- According to a particular embodiment, the keypad comprises a transparent or translucent sticker positioned above the light system and having an internal face provided with a capacitive circuit forming the touch keys. Preferably, the capacitive circuit is made of transparent conductive ink.
- According to another embodiment, the keypad comprises a mask positioned above the light system and provided with two windows in the first light zone, two windows in the second light zone, and two windows in the third light zone.
- Preferably, the mask is arranged on an external face of the sticker. The mask can be painted, inked, or glued on the external face of the sticker.
- According to an alternate embodiment, the windows can be formed directly in a wall of an outer component of the electric vehicle. Preferably, the wall comprises an opaque material, and a translucent or transparent material. The windows can be delimited by six parallel grooves formed in the opaque material and covered by the translucent or transparent material.
- In the second mode, the set of diodes preferably illuminate the first light zone in a first color, the second light zone in a second color, and the third light zone in a third color. Alternately, in the second mode, the first zone and the third zone may be of the same color.
- In the first mode, the light zones are preferably illuminated by only one color at the same time, this color depending on the state of charge of the electric vehicle.
- In a preferred embodiment of the first mode, the light system has at least three operating states: a first state in which the set of diodes illuminate the first light zone in a first color; a second state in which the set of diodes illuminate the first light zone and the second light zone in a second color; and a third state in which the set of diodes illuminate the first light zone, the second light zone and the third light zone in a third color.
- Preferably, the keypad comprises light guides surrounded by the set of diodes, wherein: the first light zone comprises a first light guide, the second light zone comprises a second light guide, the third light zone comprises a third light guide.
- Still preferably, the light guides and the set of diodes are mounted on a printed circuit board.
- In a first embodiment, the set of diodes comprises: one diode of the first color for illuminating the first light zone in the first state; two diodes of the second color for illuminating the first light zone and the second light zone in the second state; three diodes of the third color for illuminating the first light zone, the second light zone and the third light zone in the third state.
- In a second embodiment, the set of diodes comprises: two diodes of the first color for illuminating the first light zone in the first state, or the first light zone and the second light zone in the second state; three diodes of the third color for illuminating the first light zone and the second light zone in the second state, or the first light zone, the second light zone and the third light zone in the third state; wherein in the second state, a mix of the first color and the third color forms the second color in the first light zone and the second light zone.
- Preferably, the keypad forms a module for illuminating an outer component of the electric vehicle. More preferably, the outer component is located next to the electric charging hatch of the electric vehicle. For example, the component is a B pillar capping. The light system may be provided with a cover designed for mounting in a particular location of the outer component.
- In a preferred embodiment, the light zones are positioned along a straight line. Preferably, the light zones are more extended perpendicular to the straight line than along the straight line.
- In another embodiment, the light zones are positioned along a curved line. Preferably, the light zones are more extended along the curved line than perpendicular to the curved line.
- In a particular embodiment, the set of diodes illuminate the light zones continuously in each of the operating states.
- In another embodiment, the set of diodes illuminate the light zones discontinuously in each of the operating states in the first mode.

More precisely, during a battery charging process, in the first state, the set of diodes illuminate the first light zone in the first color during a predetermined time, then is turned off during a predetermined time, and so on; in the second state, the set of diodes illuminate the first light zone in the second color during a predetermined time, then the first light zone and the second light zone in the second color during a predetermined time, then is turned off during a predetermined time; and in the third state, the set of diodes illuminate the first light zone in the third color during a predetermined time, then the first light zone and the second light zone in the third color during a predetermined time, then the first light zone, the second light zone and the third light zone in the third color during a predetermined time, then is turned off during a predetermined time, and so on.

Preferably, all predetermined times are equal.

More preferably, all predetermined times are equal to 1 second.
- In a preferred embodiment, the light system activates the first state when the state of charge is in a low range, the second state when the state of charge is in a medium range, and the third state when the state of charge is in a high range.

For example:
- the low range corresponds to the first third of charge (0-33%),
- the medium range corresponds to the second third of charge (33-66%), and
- the high range corresponds to the third third of charge (66-100%).
- During a battery charging process, the high range can be divided in two sub-ranges: an inferior sub-range in which the set of diodes illuminate the first light zone in the third color during a predetermined time, then the first light zone and the second light zone in the third color during a predetermined time, then the first light zone, the second light zone and the third light zone in the third color during a predetermined time, then is turned off during a predetermined time, and so on; and a superior sub-range in which the set of diodes illuminate the first light zone, the second light zone and the third light zone in the third color during a predetermined short time, then is turned off during a predetermined long time, and so on.

For example:
- the inferior sub-range corresponds to 66-99%,
- the superior sub-range corresponds to 99-100%,
- the predetermined short time is equal to 100 ms,
- the predetermined long time is equal to 2 seconds.
- During a battery charging process, the low range can be divided in two sub-ranges: an inferior sub-range in which the set of diodes illuminate the first light zone in the first color during a predetermined short time, then is turned off during a predetermined short time, and so on; and a superior sub-range in which the set of diodes illuminate the first light zone in the first color during a predetermined short time, then is turned off during a predetermined short time, and so on.

For example:
- the inferior sub-range corresponds to 0-5%,
- the superior sub-range corresponds to 5-33%,
- the predetermined short time is equal to 100 ms,
- the predetermined long time is equal to 1 second.

The invention also concerns a method for unlocking/locking at least one opening of an electric vehicle, by implementing a keypad as mentioned above. In the second mode, the light system displays the touch keys illuminated with different colors, and the unlocking/locking of the at least one opening is performed by touching a predetermined sequence of colors on the touch keys.

### BRIEF DESCRIPTION OF THE DRAWINGS

The invention will now be explained in correspondence with the annexed figures, and as an illustrative example, without restricting the object of the invention. In the annexed figures:
- figure 1 is a perspective view of an outer component of an electric vehicle having a location designed for receiving a light system according to the invention;
- figure 2 is a sectional view of the location along line II-II of figure 1; with the keypad mounted on the outer component;
- figure 3 is a front view of the internal face of a sticker provided with capacitive keys, equipping the keypad;
- figure 4 is a front view of the external face of the sticker, provided with a mask comprising six parallel windows;
- figure 5 is an upper view of the light system equipping the keypad;
- figure 6 is an outside view of the outer component equipped with the keypad operating in a first state of the first mode;
- figure 7 is an upper view of the light system operating in the first state;
- figure 8 is an outside view of the outer component equipped with the keypad operating in a second state of the first mode;
- figure 9 is an upper view of the light system operating in the second state;
- figure 10 is an outside view of the outer component equipped with the keypad operating in a third state of the first mode;
- figure 11 is an upper view of the light system operating in the third state;
- figure 12 is a view similar to figures 6, 8 and 10, showing the keypad operating in the second mode, with the keys illuminated with different colors;
- figure 13 is an upper view of the light system operating in the second mode;
- figure 14 is an upper view similar to figure 9, showing a light system according to a second embodiment of the invention, operating in the second state of the first mode;
- figure 15 is an upper view showing the light system of figure 14, operating in the second mode;
- figure 16 is a view similar to figure 12, showing a keypad according to a third embodiment of the invention; and
- figure 17 is a front view of the internal face of a sticker provided with capacitive keys, equipping the keypad of figure 16.

### DETAILED DESCRIPTION OF SOME EMBODIMENTS

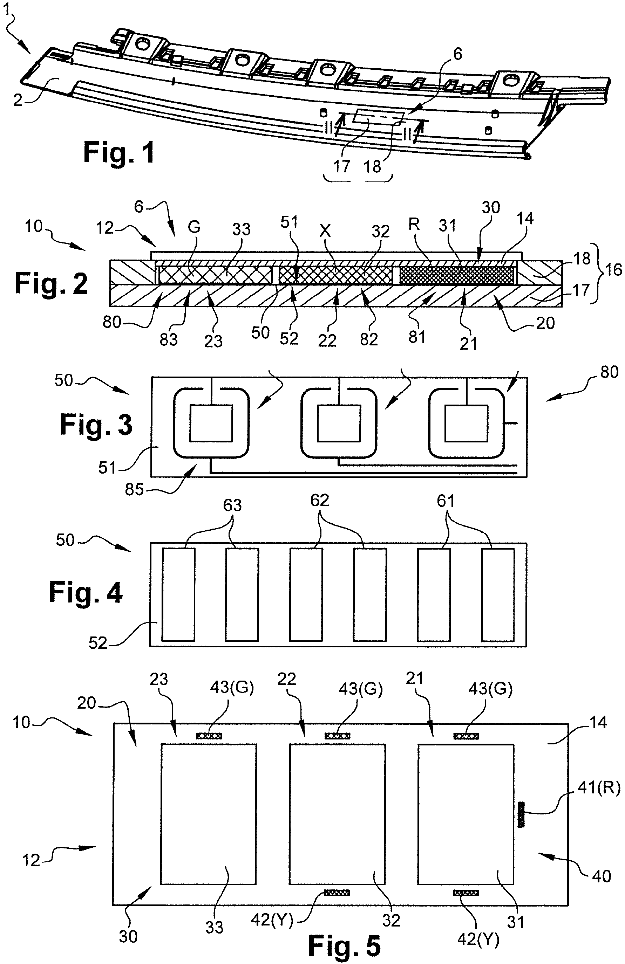

Figures 1 to 13 illustrates a keypad (10) according to a first embodiment of the invention, for unlocking/locking at least one opening of an electric vehicle (1).

Preferably, the keypad (10) is used for unlocking/locking the electric charging hatch of the vehicle (1). Additionally or alternatively, the keypad (10) may be used for commanding other openings, such as the doors and the rear trunk of the vehicle (1).

Figure 1 shows an outer component (2) of the vehicle (1), having a location (6) designed for receiving the keypad (10). More precisely, the outer component (2) is a B pillar capping.

The keypad (10), not shown, will be positioned at a dedicated location (6), against a wall (16) of the outer component (2). More precisely, the wall (16) comprises a translucent or transparent material (17), and an opaque material (18). The location (6) is a recess formed in the opaque material (18) so that the keypad (10) will be visible from outside the vehicle (1) through the translucent or transparent material (17).

Figure 2 to 5 show the keypad (10) and its constitutive elements.

The keypad (10) comprises a light system (12), designed for indicating a state of charge of the battery of an electric vehicle (1). The light system (12) includes light guides (30) and diodes (40) mounted on a printed circuit board (14).

The light system (12) defines three light zones (20) including a first light zone (21), a second light zone (22) and a third light zone (23) forming a dynamic display. The first light zone (21) comprises a first light guide (31). The second light zone (22) comprises a second light guide (32). The third light zone (23) comprises a third light guide (33).

The light guides (30), and consequently the light zones (20), are positioned along a straight line. Preferably, the light guides (30) and light zones (20) are more extended perpendicular to the straight line than along the straight line.

The light guides (30) are surrounded by the set of diodes (40), designed for illuminating the light zones (20) with different colors (R, Y, G). A red diode (41), a yellow diode (42) and a green diode (43) are placed next to the first light guide (31). A yellow diode (42) and a green diode (43) are placed next to the second light guide (32). A green diode (43) is placed next to the third light guide (32).

The keypad (10) further comprises a transparent or translucent sticker (50). The sticker (50) is a film arranged between the light system (12) and the wall (16), more precisely between the light guides (30) and part (17) of the wall (16).

The sticker (50) has an internal face (51) provided with a capacitive circuit (85) forming capacitive touch keys (80). The capacitive circuit (85) comprises tracks of electric conductive ink arranged to define the capacitive keys (80). Preferably, the capacitive circuit (85) is made of transparent conductive ink. The capacitive keys (80) comprises a first key (81) positioned in the first light zone (21), a second key (82) positioned in the second light zone (22), and a third key (83) positioned in the third light zone (23).

The sticker (50) has an external face (52) provided with a mask (56). In practice, the mask (56) can be painted, inked, or glued on face (52). The mask (56) is provided with six windows (61, 62, 63) designed to face different light zones (20) of the light system (12). Preferably, all light zones (20) have the same dimensions, and all windows (61, 62, 63) have the same dimensions. Two windows (61) are positioned above the light guide (31) and key (81), two windows (62) are positioned above the light guide (32) and key (82), and two windows (63) are positioned above the light guide (33) and key (82).

Thus, the colors (R, Y, G) are visible through the windows (61, 62, 63) of sticker (50) from outside the vehicle (1). When pressing on one of the window (61, 62, 63), the user presses on the corresponding key (81, 82, 83).

The light system (12) is programmed with two modes (M1, M2).

In the first mode (M1), the light system (12) displays an information relative to the electric vehicle (1), such as a state of charge of the electric vehicle (1) in the example of the Figures.

In the second mode (M2), the light system (12) displays the keys (80) illuminated with different colors (R, Y, G). The unlocking/locking of the opening is performed by touching a predetermined sequence of colors on the keys.

The transition from the first mode (M1) to the second mode (M2) can be made simply by pressing one of the keys (80). The transition from the second mode (M2) to the first mode (M1) can be made automatically after a predetermined time, for example five seconds, without pressing one of the keys (80).

The first mode (M1) is programmed with three operating states (S1, S2, S3), as described here-after.

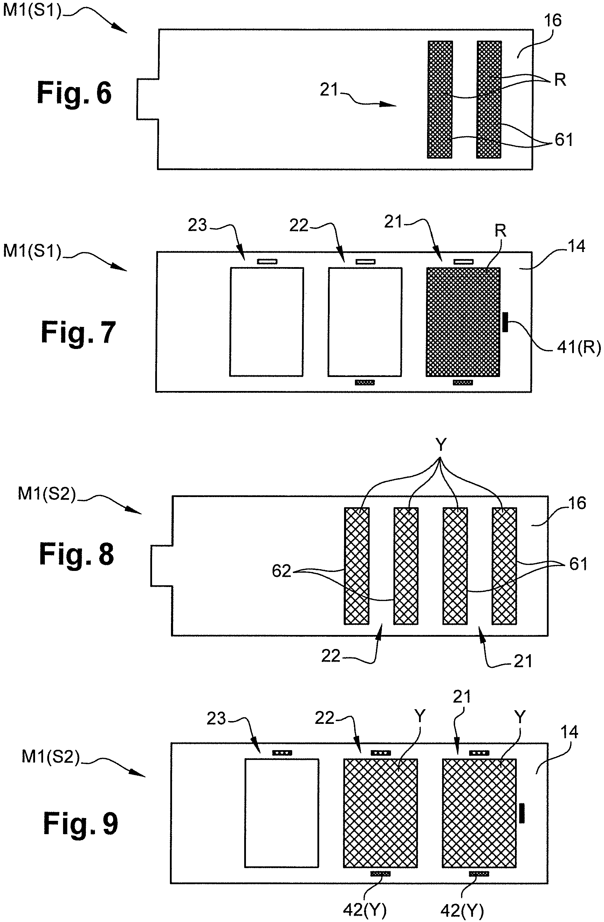

Figures 6 and 7 show a first state (S1), in which the red diode (41) illuminates the first light zone (21) and the two windows (61) in a red color (R).

Figures 8 and 9 show a second state (S2), in which the yellow diodes (42) illuminate the first and second light zones (21, 22) and the four windows (61, 62) in a yellow color (Y).

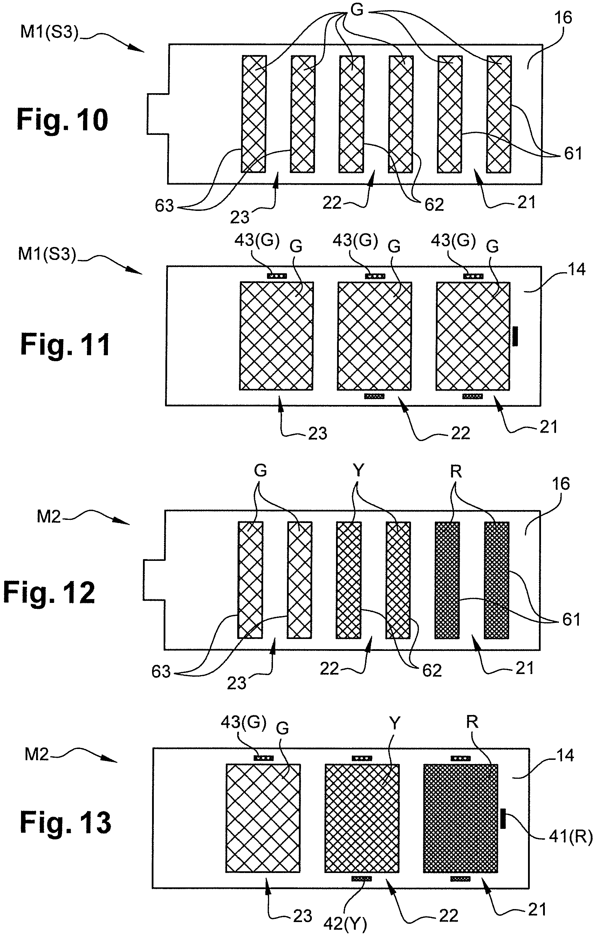

Figures 10 and 11 show a third state (S3), in which the green diodes (43) illuminate the first, second and third light zones (21, 22, 23) and the six windows (61, 62, 63) in a green color (G).

Figures 12 and 13 show the second mode (S3), in which the red diode (41) illuminates the first light zone (21) and the two windows (61) in a red color (R), a yellow diode (42) illuminates the second light zone (22) and the two windows (62) in a yellow color (Y), and a green diode (43) illuminates the third light zone (23) and the two windows (63) in a green color (G).

Thus, the keypad (10) provides a lighting function in addition to the unlocking/locking function. The light system (12) illuminates the outer component (2), by forming a dynamic logo indicating the different levels of charge of the electric battery in the first mode (M1), or by forming a luminous keypad (10) displaying the keys (80) in different colors in the second mode (M2). Thanks to the six windows (61, 62, 63), the dynamic logo comprises six bars indicating three levels of charge. Different flashing patterns of the diodes (40) can be programmed to provide further information about the state of charge.

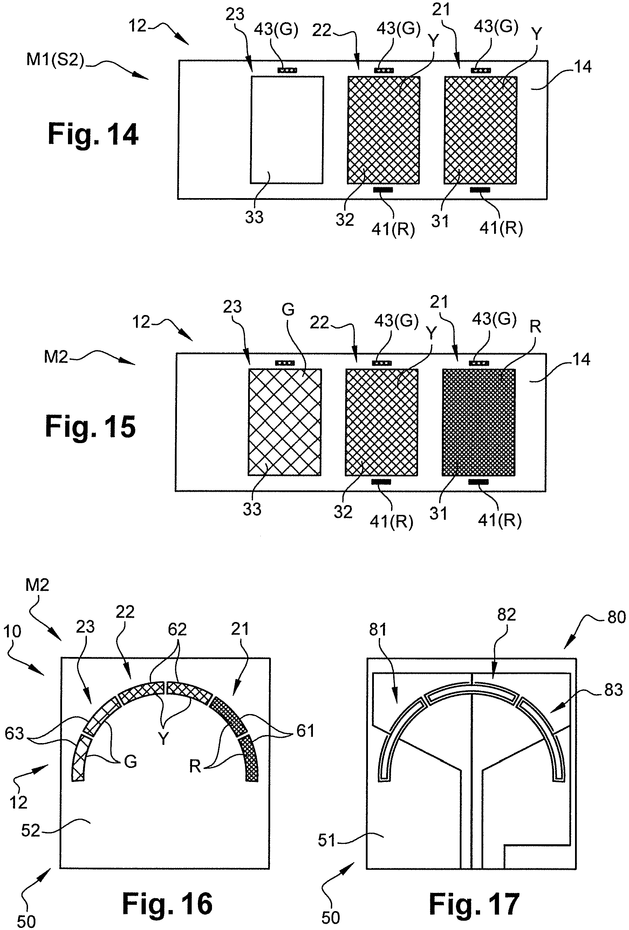

Other embodiments of the invention are represented on figures 14 to 17. In these embodiments, elements similar to the first embodiment have the same references and work in the same way. Only the differences with respect to the first embodiment are described hereafter.

Figures 14 and 15 shows a light system (12) according to a second embodiment of the invention, wherein the set of diodes (40) comprises only five diodes (40), more precisely two red diodes (41) and three green diodes (43), without yellow diode.

In the first state (S1) not shown, the first zone (21) is illuminated by a red diode (41).

In the second state (S2), each of the first and second zones (21, 22) is illuminated by a red diode (41) and a green diode (43). The mix of red color (R) and green color (G) illuminate the first and second zones (21, 22) with a yellow color (Y).

In the third state (S3) not shown, each of the first, second and third zones (21, 22, 23) is illuminated by a green diode (43).

In the second mode (M3), the first zone (21) is illuminated by a red diode (41), the second zone (22) is illuminated by a red diode (41) and a green diode (43), and the third zone (23) is illuminated by a green diode (43).

Figures 16 and 17 shows a keypad (10) according to a third embodiment of the invention, wherein the light zones (20) and keys (80) are positioned along a curved line. The light system (12) is programmed with the two modes (M1, M2) and three states (S1, S2, S3), as described here-above. Preferably, the light zones (20) are more extended along the curved line than perpendicular to the curved line.

Other non-shown embodiments can be implemented within the scope of the invention.

For example, the keypad (10) can have four keys (80) associated with four light zones (20), or more than four. In this case, the light system (12) is arranged accordingly.

According to another example, the windows (61, 62, 63) can be formed directly in the wall (16) of component (2). The windows (61, 62, 63) can be delimited by six parallel grooves formed in the opaque material and covered by the translucent or transparent material. In this case, the keys (80) are formed accordingly.

According to another example, the light system (12) can be designed to display an information different from a state of charge of the electric vehicle (1), such as a signal quality level, a parking payment time, a vehicle rent time, etc.

In addition, technical features of the different embodiments can be, in whole or part, combined with each other. Thus, the keypad (10) can be adapted to the specific requirements of the application.

## Claims

1. A keypad (10) for unlocking/locking at least one opening of an electric vehicle (1), the keypad (10) comprising at least three touch keys (80) including a first touch key (81), a second touch key (82) and a third touch key (83); wherein the keypad (10) includes a light system (12) comprising:
- at least three light zones (20) including a first light zone (21) provided with the first touch key (81), a second light zone (22) provided with the second touch key (82), and a third light zone (23) provided with a third touch key (83); and
- a set of diodes (40) for illuminating the light zones (20) in different colors (R, Y, G);
wherein in a first mode (M1), the light system (12) displays an information relative to the electric vehicle (1),
while in a second mode (M2), the light system (12) displays the touch keys (80) illuminated with different colors (R, Y, G).

2. The keypad (10) according to claim 1, wherein in the first mode (M1), the information displayed by the light system (12) is a state of charge of the electric vehicle (1).

3. The keypad (10) according to any one of the previous claims, wherein the second mode (M2) is activated by pressing one of the touch keys (80).

4. The keypad (10) according to any one of the previous claims, wherein in the second mode (M2), when a user enters an unknown sequence, the light zones (20) are illuminated with a predetermined pattern during a predetermined time.

5. The keypad (10) according to any one of the previous claims, comprising a sticker (50) positioned above the light system (12) and having an internal face (51) provided with a capacitive circuit (85) forming the touch keys (80).

6. The keypad (10) according to any one of the previous claims, comprising a mask (56) positioned above the light system (12) and provided with two windows (61) in the first light zone (21), two windows (62) in the second light zone (22), and two windows (63) in the third light zone (23).

7. The keypad (10) according to claims 5 and 6, wherein the mask (56) is arranged on an external face (52) of the sticker (50).

8. The keypad (10) according to any one of the previous claims, wherein in the second mode (M2), the set of diodes (40) illuminate the first light zone (21) in a first color (R), the second light zone (22) in a second color (Y), and the third light zone (23) in a third color (G).

9. The keypad (10) according to any one of the previous claims, wherein in the first mode (M1), the light zones (20) are illuminated by only one color (R; Y; G), depending on the state of charge of the electric vehicle (1).

10. The keypad (10) according to any one of the previous claims, wherein in the first mode (M1), the light system (12) has at least three operating states (S1, S2, S3):
- a first state (S1) in which the set of diodes (40) illuminate the first light zone (21) in a first color (R);
- a second state (S2) in which the set of diodes (40) illuminate the first light zone (21) and the second light zone (22) in a second color (Y); and
- a third state (S3) in which the set of diodes (40) illuminate the first light zone (21), the second light zone (22) and the third light zone (23) in a third color (G).

11. The keypad (10) according to claim 10, comprising light guides (30) surrounded by the set of diodes (40), wherein:
- the first light zone (21) comprises a first light guide (31),
- the second light zone (22) comprises a second light guide (32),
- the third light zone (23) comprises a third light guide (33).

12. The keypad (10) according to any one of the previous claims 10 or 11, wherein the set of diodes (40) comprises:
- one diode (41) of the first color (R) for illuminating the first light zone (21) in the first state (S1);
- two diodes (42) of the second color (Y) for illuminating the first light zone (21) and the second light zone (22) in the second state (S2);
- three diodes (43) of the third color (G) for illuminating the first light zone (21), the second light zone (22) and the third light zone (23) in the third state (S3).

13. The keypad (10) according to any one of the previous claims 10 or 11, wherein the set of diodes (40) comprises:
- two diodes (41) of the first color (R) for illuminating the first light zone (21) in the first state (S1), or the first light zone (21) and the second light zone (22) in the second state (S2);
- three diodes (43) of the third color (G) for illuminating the first light zone (21) and the second light zone (22) in the second state (S2), or the first light zone (21), the second light zone (22) and the third light zone (23) in the third state (S3);
wherein in the second state (S2), a mix of the first color (R) and the third color (Y) forms the second color (Y) in the first light zone (21) and the second light zone (22).

14. The keypad (10) according to any one of the previous claims, forming a module for illuminating an outer component (2) of the electric vehicle (1).

15. A method for unlocking/locking at least one opening of an electric vehicle (1), by implementing a keypad (10) according to any one of the preceding claims, wherein in the second mode (M2), the light system (12) displays the touch keys (80) illuminated with different colors (R, Y, G), and the unlocking/locking of the at least one opening is performed by touching a predetermined sequence of colors (R, Y, G) on the touch keys (80).
